Europäisches Patentamt

European Patent Office

Office européen des brevets

(11) Publication number: 0 373 363
A2

## (12) EUROPEAN PATENT APPLICATION

(21) Application number: 89120835.7

(22) Date of filing: 10.11.89

(51) Int. Cl.5: H05K 3/00, B29C 67/18, B29C 43/18

(30) Priority: 15.12.88 US 284532

(43) Date of publication of application:
20.06.90 Bulletin 90/25

(84) Designated Contracting States:
DE FR GB

(71) Applicant: International Business Machines
Corporation
Old Orchard Road
Armonk, N.Y. 10504(US)

(72) Inventor: Lazzarini, Donald Joseph
909 Murray Hill Road
Binghamton New York 13903(US)
Inventor: Samuelson, Carl Edwin
2117 Farm-To-Market Road
Johnson City New York 13790(US)
Inventor: Wiley, Robert Taylor
14 Lincoln Avenue
Endicott New York 13760(US)

(74) Representative: Klocke, Peter, Dipl.-Ing.
IBM Deutschland GmbH Patentwesen und
Urheberrecht Schönaicher Strasse 220
D-7030 Böblingen(DE)

(54) Filling of vias in a metallic plane.

(57) Vias in a metallic plane of a desired thickness with a dielectric by providing a layer of dielectric material (5) between two sheets (1, 2) containing clearance holes (3, 4) of the metal of the metallic plane wherein the total thickness of the two sheets corresponds to the desired thickness. Also provided on each sheet is a mask (6, 7) having clearance holes that correspond to the clearance holes in the sheets. On each mask is provided a layer of dielectric (8, 9) and on each layer of dielectric is provided a release layer (10, 11). The composite is laminated to thereby cause dielectric from the layer between the two sheets and the layers adjacent the mask to fill the clearance holes and to bond the metallic planes together. The mask, remaining dielectric adjacent the mask, and release layer are then removed.

FIG. I

DIAGRAM I - LAY UP FOR LAMINATION

## FILLING OF VIAS IN A METALLIC PLANE

The present invention is concerned with a method for filling vias in a metallic plane with dielectric material.

Circuit boards and circuit cards find a wide variety of uses in the electronics industry.

A widely employed technique for preparing such is to impregnate a woven fiberglass sheet with a resin composition and then laminate a copper sheet to at least one of the sides in the resin-impregnated fiberglass sheet.

Next, an electrical circuit is etched into the copper to form the circuit board or card and then electrical connections can be provided to it when it is used. Typically, power supply modules include a number of components surface-mounted onto a circuitized card or board.

The card or board includes a relatively thick, metallic plane, usually of copper, a relatively thin layer of dielectric, such as an epoxy-fiberglass prepreg, and metallic circuitry, such as copper circuitry employing about three-ounce copper.

The relatively thick, metallic plane includes clearance holes that provide for selective electrical connections which are electrically isolated or insulated from the relatively thick, metallic plane.

In addition, the borders of the relatively thick, metallic planes are provided with dielectric to provide isolation slots and isolation borders.

As the thickness of the metallic power planes increases, so does the difficulty in assuring filling of the clearance holes with the dielectric material to provide isolation of high reliability and integrity. In particular, difficulties have occurred in providing continuous dielectric material in the clearance holes which are free from voids that could result in undesired electrical connections in the subsequent fabrication of the board or card.

Also, the technique of filling must be such that upon subsequent processing, dielectric material is not accidentally removed from the clearance holes.

The invention as claimed is intended to remedy these drawbacks.

The present invention is concerned with a method for filling vias in a metallic plane with a dielectric material.

In particular, the method of the present invention is concerned with filling clearance holes in a relatively heavy metallic plane with dielectric material that is at least substantially, if not entirely, free from voids and bubbles.

In addition, the method of the present invention makes it possible to fill the clearance holes at the same time that isolation borders in the planes are also filled. The process of the present invention insures complete filling of the clearance holes with the dielectric material without it being susceptible to pull-out upon subsequent processing.

More particularly, the present invention is concerned with a method for filling vias in a metallic plane of a desired thickness with a dielectric.

The method includes providing a layer of dielectric between two sheets containing vias of the metal of the metallic plane. Each sheet individually is about 25% to about 75% of the desired thickness of the metallic plane and the total thickness of the two sheets corresponds to the desired thickness of the metallic plane.

On the major surface of each of the two sheets that is remote from the adhesive is provided a mask that has vias which correspond or match-up to the vias in the metal sheets. On the surface of each of the masks remote from the metal sheets is provided a layer of dielectric material. On the surface of each of the layers of dielectric material that is remote from the mask is provided a release layer.

The composite assembly is then laminated to cause dielectric material from the layer between the two sheets and the layer adjacent each mask to fill the vias and to bond the metallic sheets together.

Next, the mask, remaining dielectric adjacent to the mask, and release layer are removed to thereby obtain a metallic plane with vias filled with dielectric. The removal of the dielectric, mask, and release layer does not result in a concomitant removal of dielectric from within the vias of the metallic plane.

The presence of the dielectric layer between the two sheets of metal helps assure that the vias will be filled with dielectric and that voids or bubbles will not occur to any great extent in the interior of the vias. In particular, the problems of voids in the dielectric in prior art processes tend to be greater within the vicinity of the center of the metallic plane, especially with the relatively heavy metallic planes of about 254 $\mu$m (10 mils) and greater.

The method of the present invention is especially advantageous for filling clearance holes in relatively heavy, or thick, metallic planes, such as copper planes, having a total thickness of at least 254 $\mu$m (10 mils). The method of the present invention is especially suitable for filling clearance holes and providing isolation borders in relatively heavy copper power planes.

For a better understanding of the present invention, together with further objects and advantages, preferred embodiments of the invention are described in the following with reference to the accompanying drawings, in which:

Figure 1 is a schematic diagram of the composite prior to the lamination in accordance with the present invention.

Figure 2 is a schematic diagram of the product achieved by the process of the present invention.

The present invention is concerned with filling vias in a metallic plane of a desired thickness with a dielectric material. The process of the present invention is especially concerned with filling vias in relatively heavy metallic planes, such as those of about 85 g (3 ounces) to about 567 g (20 ounces) of copper. The preferred metal being copper.

Pursuant to the present invention, a dielectric layer is provided between two sheets of the metal of the metallic plane which, in the preferred aspects of the present invention, would be two sheets of copper. Each sheet of metal individually is about 25% to about 75%, preferably about 40% to about 60%, and most preferably about 50% of the desired thickness of the metallic plane. The total thickness of the two sheets will correspond, or be equal to, the desired thickness of the metallic plane.

The dielectric material employed must be capable of bonding the metal sheets together after a subsequent lamination step and must be capable of flowing into the vias during the subsequent lamination step. Also, the dielectric should provide good adhesion to the side walls of the vias.

Suitable dielectric material include thermosetting resinous materials and thermoplastic resins and include those which have been suggested as dielectric substrates for use as integrated circuit substrates.

Typical thermosetting resinous materials include epoxy, phenolic-based materials, and polyamides. Such materials are usually molded of the resinous material, along with a reinforcing agent such as being a glass-filled epoxy or phenolic-based material. Examples of some phenolic type materials include copolymers of phenol, resorcinol, and cresol. Examples of some suitable thermoplastic polymeric materials include polyolefins, such as polypropylene, polysulfones, polycarbonates, nitrile rubbers, and ABS polymers.

The preferred polymeric materials employed in accordance with the present invention are epoxy resinous materials. Typical epoxy resinous materials include the bisphenol A type resins obtained from bisphenol A and epichlorohydrin, brominated polyepoxides obtained from tetrabromo bisphenol A and epichlorohydrin, resinous materials obtained by the epoxidation of novolak resins produced from a phenolic material such as phenol or cresol, and an aldehyde such as formaldehyde with epichlorohydrin, polyfunctional epoxy resins such as tetraglycidyldiaminodiphenyl methane and alicyclic epoxy resins such as bis(3,4-epoxy-6-methyl-cyclohexyl methyl) adipate.

The epoxy resinous compositions also can contain accelerating and curing agents as well-known in the art. Examples of suitable curing agents include polyamines, primary, secondary, and tertiary amines, polyamides, polysulfides, urea-phenol-formaldehyde and acids or anhydrides thereof. In addition, suitable curing agents include Lewis acid catalysts such as $BF_3$ and complexes thereof.

Many of the dielectric layers employed in accordance with the present invention are referred to as so-called "prepreg" which contain a resin and a reinforcing fiber such as fiberglass. Such compositions containing fibers are usually prepared by impregnating the fibers with, for instance, an epoxy composition. The amount of epoxy composition is usually about 30% to about 70% by weight and preferably about 50% to about 65% by weight of the total solids content of the epoxy composition in the fiberglass.

After combining with the resinous fibers, the composition is cured to the B-stage and cut to the desired shape, such as a sheet. The thickness of the sheets of dielectric are usually about 38.1 to about 76.2 $\mu$m (1.5 to about 3 mils). In accordance with the present invention, one or two sheets of the dielectric are placed between the metal sheets. The dielectric employed is preferably an epoxy impregnated fiberglass of the type disclosed in US-A-3 523 037. In particular, such contains about 70 to about 90 parts per 100 parts by weight of resin solids of a polyepoxide being tetrabrominated diglycidyl ether of a phenol; about 10 to about 30 parts per 100 parts by weight of resin solids of an epoxy polymer having functionality of about 3.5 to about 6; about 3 to about 4 parts per 100 parts by weight of resin solids of dicyandiamide; and about 0.2 to about 0.4 parts per 100 parts by weight of resin solids of a tertiary amine.

The preferred brominated epoxy polymers have an epoxy equivalent of about 455 to about 500, a functionality of about 2, and a bromine content of about 19% to about 23% by weight. Such are supplied by Ciba Products Co. under the trade name Araldite 8011 as a solution containing 75% epoxy resin by weight in methyl-ethylketone or by Dow Chemical Company under the trade designation DER-511 as an 80% solution in methyl-ethylketone.

Examples of epoxy polymers having functionality of about 3.5 to about 6 include the epoxidized phenolic novolak polymers. A preferred epoxidized novolak being cresol-formaldehyde novolak under the trade designation Araldite 1280 from Ciba-Geigy.

Suitable tertiary amines are benzyldimethylamine, α-methyl benzyldimethylamine, dimethylaminomethylphenol, and tris (dimethylaminomethylphenol) with $N,N,N',N'$-tetramethyl-1,3-butane diamine.

The preferred dielectric, referred to as a prepreg, can be prepared using the type of equipment and process disclosed in US-A-3 523 037.

A mask is provided on the major surface of each of the metallic sheets that is remote from the dielectric layer. The mask has vias that correspond or line up to the vias in the metal sheets. The mask should be a material that can be readily removed from the structure after the lamination step and preferably is a copper sheet and preferably being about 25.4 to about 76.2 μm (1 to about 3 mils) thick. Such are commercially available from Gould and Yates and are generally referred to as electro-deposited copper foils. These copper foils have one very smooth surface while the other surface is nodular or irregular. Preferred copper foils are about 35.56 to about 71.12 μm (1.2 to about 1.4 mils) thick and are usually referred to as one-ounce or two-ounce copper. In order to facilitate removal of the mask subsequent to the lamination, the smooth surface of the foil is placed adjacent the metal sheets.

On the major surface of each of the masks is provided a layer of dielectric material. The polymeric material of the dielectric layer must be capable of flowing into the vias during the lamination step and of forming a bond with the interior of the clearance holes. Also, such should have a dielectric constant at least as high as the polyepoxide or higher. Also, it should be capable of forming good adhesion to subsequently applied layers during further processing and preferably to hold up to temperatures that are used for subsequent soldering. The types of dielectric materials discussed above for the layer between the two metallic sheets can be used for this dielectric layer with the preferred being the same preferred material as the dielectric layer between the sheets discussed above. Preferably, the thickness of these layers of polymeric material are about 25.4 to about 254 μm (1 to about 10 mils) and most preferably about 50.8 to about 152.4 μm (2 to about 6 mils). During the lamination only the polymeric material from the preferred prepregs will flow or migrate into the vias. The fiberglass reinforcement remains as is, but facilitates obtaining uniform distribution of the polymeric material during the lamination step and also holds the material in the clearance holes and isolation slots.

In order to facilitate the lamination, a release sheet is placed on each major surface of the dielectric layer that is remote from the mask. The release sheet precludes adhesion of the dielectric material to the plates of the laminating equipment. Suitable release sheets include polyvinylfluoride, available under the trade designation Tedlar and polyethyleneterephthalate. The release sheet is usually about 25.4 to about 50.8 μm (1 to about 2 mils) thick and preferably about 25.4 to about 38.1 μm (1 to about 1.5 mils) thick.

The assembly is then laminated, causing the dielectric from the layer between the two sheets and the layers adjacent the mask to fill the vias and to bond the metallic sheets together. In addition, any isolation borders or slots already formed in a particular structure will also have the dielectric material flow therein. The presence of the layer between the two sheets not only provides material to enter the clearance holes, but also holds the final structure together, which can be subsequently milled to provide additional isolation borders which can then be filled. The presence of the adhesive precludes more complicated processing to prevent the structure from falling apart due to subsequent milling. The lamination is carried out under conditions of temperature, pressure, and time such that the polymer from the dielectric is further cured, but not fully cured so that it is available to facilitate adherence to further layers during subsequent processing.

The laminating can be carried out by pressing together the desired structure in a preheated laminating press at a predetermined pressure and temperature as, for example, about 137.9 kPa (200 psi) to about 3447 kPa (500 psi), typical of which is about 3447 kPa (500 psi) at temperatures of about 177°C (350°F). The time of the pressing operation should be such as to provide further curing of the polymer, but preferably not to fully cure it. About 15 minutes is adequate for the above conditions.

Next, the mask, remaining dielectric adjacent the mask, and release layer are removed by simple peeling of the layers. The removal does not result in a concomitant removal of dielectric material from within the vias of the structure.

To further illustrate the present invention, reference is made to the Figures.

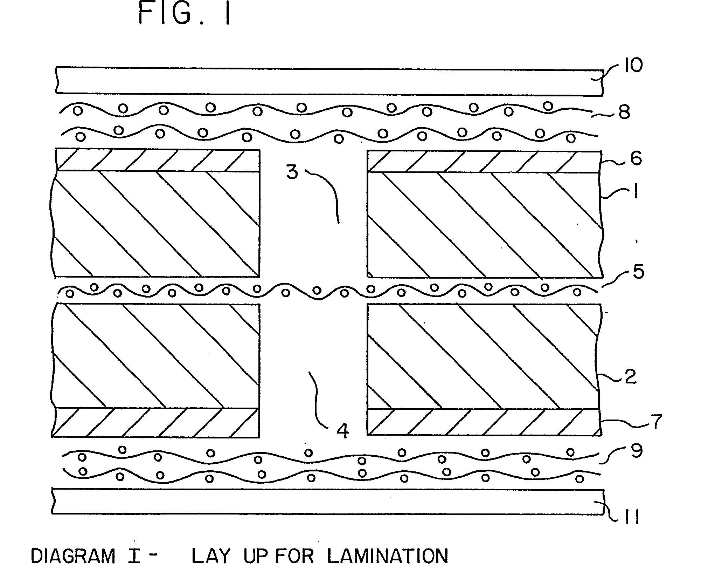

Figure 1 illustrates an assembly for lamination pursuant to the present invention. In particular, numerals (1) and (2) each represent a metal layer having clearance hole (3) and (4) respectively lined up with each other. A dielectric layer (5) is provided between metal sheets (1) and (2). On metal sheets (1) and (2) is copper mask (6) and (7) respectively, having a via that corresponds to the via in the metal sheet. A layer of dielectric (8) is provided on mask (7) and a layer of dielectric (9) is provided on mask (7). Release sheet (10) is provided on dielectric layer (8) and a release sheet (11) is provided on dielectric layer (9).

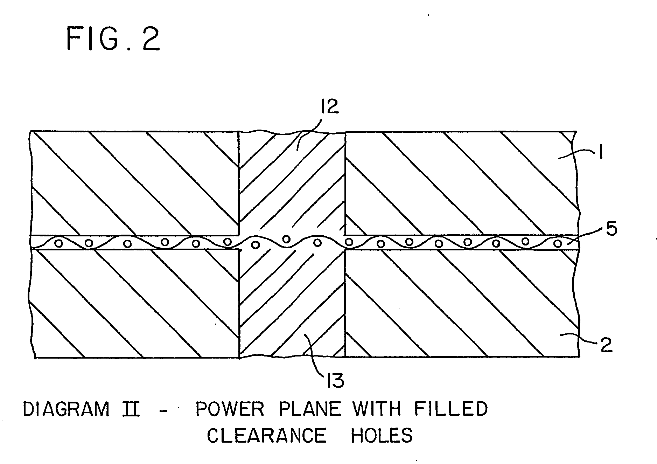

Reference to Figure 2 schematically illustrates a metallic plane obtained in accordance with the present invention being filled with dielectric material (12) and (13).

## Claims

1. A method for filling vias in a metallic plane of a desired thickness with a dielectric which comprises:

a) providing a layer of dielectric between two sheets containing vias of the metal of the metallic plane wherein each sheet individually is about 25% to about 75% of the desired thickness of the metallic plane, the total thickness of the two sheets corresponding to the desired thickness of the metallic plane;

b) providing on the major surface of each of the metal sheets remote from the dielectric layer, a mask having vias that correspond to the vias in the metal sheets;

c) providing on the major surface of each of the masks remote from the metal sheets a layer of dielectric material;

d) providing on the major surface of each of the layers of dielectric material remote from the mask, a release layer;

e) laminating the composite to thereby cause dielectric from the layer between the two sheets and the layers adjacent the mask to fill the vias and to bond the metallic sheets together; and

f) removing the mask, remaining dielectric adjacent the mask, and release layer to thereby obtain a metallic plane with filled vias.

2. The method of claim 1 wherein each sheet individually is about 40% to about 60%, preferably about 50% , of the desired thickness.

3. The method of claim 1 or 2 wherein said metallic plane is copper.

4. The method of any one of the preceding claims wherein at least one of said dielectric layers is an epoxy prepreg, preferably containing fiberglass.

5. The method of claim 4 wherein the dielectric adjacent the mask is an epoxy prepreg.

6. The method of any one of the preceding claims wherein the thickness of the dielectric layer beneath the two sheets is about 25.4 to about 254 μm (1 to about 10 mils).

7. The method of any one of the preceding claims wherein the mask is a copper mask.

8. The method of any one of the preceding claims wherein the laminating is carried out at a temperature of about 177° C (350° F) and a pressure of about 1379 to about 3447 kPa (200 to about 500 psi).

9. The method of claim 8 wherein the laminating is carried out for about 15 minutes.

10. The method of any one of the preceding claims wherein the mask, remaining dielectric adjacent the mask, and release layer are removed by physical means, preferably said physical means includes peeling.

IBM — EN 988 070

EP 0 373 363 A2

# FIG. 1

DIAGRAM I - LAY UP FOR LAMINATION

EP 0 373 363 A2

# FIG. 2

DIAGRAM II  -  POWER PLANE WITH FILLED
CLEARANCE  HOLES